# EUROPEAN PATENT APPLICATION

(11) **EP 0 875 926 A2**
(43) Date of publication of application: **04.11.1998**
(21) Application number: 98106466.0
(22) Date of filing: 08.04.1998
(51) Int. Cl.: H01L 21/3213, H01L 21/306, C11D 1/00

(54) **Detergent for semiconductor circuit and method for manufacturing semiconductor circuit by use of same**

(30) Priority: 11.04.1997 JP 94045/97
(71) Applicant: MITSUBISHI GAS CHEMICAL COMPANY, INC., Chiyoda-ku, Tokyo (JP)
(72) Inventor: Aoyama, Tetsuo, Mitsubishi Gas Chem. Comp. Inc., Niigata-shi, Niigata-ken (JP); Hasemi, Ryuji, Mitsubishi Gas Chem. Comp. Inc., Niigata-shi, Niigata-ken (JP); Ikeda, Hidetoshi, Mitsubishi Gas Chem. Comp. Inc., Niigata-shi, Niigata-ken (JP); Hada, Mayumi, Mitsubishi Gas Chem. Comp. Inc., Niigata-shi, Niigata-ken (JP)
(74) Representative: Türk, Gille, Hrabal

(57) **Abstract**

There are herein disclosed a detergent for a semiconductor circuit which comprises a quaternary ammonium hydroxide, a water-soluble organic solvent and water; a detergent for a semiconductor circuit which comprises a sugar and/or an sugar alcohol in addition to the above-mentioned components; and a method for manufacturing a semiconductor circuit by the use of the above-mentioned detergent.

According to the detergent for a semiconductor circuit of the present invention, a sidewall protective deposited film (a deposited polymer) formed by dry etching can easily be removed, and various kinds of metallic materials which are wire materials can be prevented from corroding, and any corrosion by the etching is not generated, either.

## Description

### BACKGROUND OF THE INVENTION

### (1) Field of the Invention

The present invention relates to a detergent for a semiconductor circuit and a method for manufacturing a semiconductor circuit by the use of the same. More specifically, it relates to a detergent for use in the manufacture of various electronic circuits such as liquid crystal display elements and semiconductor elements, and a method for manufacturing a semiconductor circuit by the use of this detergent for the semiconductor circuit.

### (2) Description of the Related Art

Heretofore, for semiconductor circuits which are formed on semiconductor wafers, aluminum has mainly been used. In recent years, electro-migration, stress migration and the like tend to occur with higher integration and miniaturization of the circuits, and therefore the migration has been inhibited by the use of aluminum alloys (Al-Si, Al-Cu, Al-Si-Cu and the like) which can be obtained by adding a trace amount of silicon or copper to aluminum. Particularly nowadays, with the further superminiaturization of the circuits, various kinds of metallic materials have been used.

A manufacturing process of a semiconductor integrated circuit which has usually been used is as follows. A photo-resist is applied onto a metallic material layer formed on an inorganic substrate, and a fine pattern is then formed by photo-lithography. Next, the whole surface of this semiconductor wafer is irradiated with ultraviolet light to cure the resist film, thereby improving the dry etching resistance of the resist pattern. Afterward, by using this resist pattern as a mask, the non-masked region of the wafer is dry-etched to form a fine circuit. At this time, a dry etching gas is used, and examples of the dry etching gas include chlorine-containing gases such as Cl₂ and Cl₂-BCl₃, and fluorine-containing gases such as CF₄, CH₂F₂ and HF.

On pattern sidewalls of the thus formed fine circuit, there is formed a photo-resist residue (hereinafter referred to simply as "deposited polymer" on occasion) which is a reaction product of the photo-resist and the dry etching gas, or a reaction product of the photo-resist, the dry etching gas and the metallic material of the metallic layer to be worked. Thus, in order to inhibit the formation of such a deposited polymer, an advanced and selective etching can be carried out by an anisotropic etching, so that a fine work is possible. On the contrary, however, there rises a problem that the formed and deposited polymer is scarcely removed. In addition, it is known that a halogen which is a component of the dry etching gas entrained in the deposited polymer during the dry etching reacts with moisture in the atmosphere after the completion of the etching to generate an acid such as a hydrogen halide, and this acid corrodes various kinds of metal materials constituting wires, thereby giving rise to a problem such as the breakage of the wires, which has a large influence on the fine circuit. This corrosion is called after-corrosion (Monthly Semicon News, the May issue in 1988, p. 44).

Examples of techniques for preventing this after-corrosion include a method of heating the wafer after the dry etching and a method of washing with a large amount of pure water, but either of these methods cannot give any successful results, so that the after-corrosion cannot completely be avoided (the above-mentioned Monthly Semicon News). Therefore, in order to prevent the after-corrosion, it is necessary to completely remove the above-mentioned deposited polymer.

In order to remove the above-mentioned deposited polymer, a washing solution such as an acidic organic solvent resist washing solution or an alkaline organic solvent resist washing solution has been used.

As the acidic organic solvent resist washing solution, a washing solution prepared by adding a phenolic compound, a chlorine-containing solvent and an aromatic hydrocarbon to an alkylbenzenesulfonic acid has usually been used, but even if a heat treatment is carried out at 100°C or more by the use of this washing solution, the deposited polymer cannot completely be removed. In addition, this kind of acidic organic solvent resist washing solution has a low solubility in water, and for this reason, it must be first washed with an organic solvent such as isopropanol having a high solubility in water, and then washed with water, which makes the process intricate.

On the other hand, similarly in the case of the above-mentioned acidic washing solution, even if the alkaline organic solvent washing solution is heated up to 100°C or more, it is fairly difficult to remove the deposited polymer. In addition, when the alkaline organic solvent washing solution is mixed with water, the resultant mixture noticeably corrodes a wire material, and therefore, after the washing, additional washing operations must be done with an organic solvent such as isopropanol having the high solubility in water and then with water, similarly in the case of the above-mentioned acidic organic solvent washing solution.

As described above, even in the case that either of the acidic and alkaline washing solutions is used, the deposited polymer cannot be removed, so that the generation of the corrosion with the remaining halogen radical and ion cannot be avoided.

In contrast to the washing method using the above-mentioned acidic organic solvent washing solution or alkaline organic solvent washing solution, another method has been suggested in which after dry etching and then plasma ashing, the resist residue is removed by the use of an aqueous solution containing a quaternary ammonium hydroxide such as tetramethylammonium hydroxide (Japanese Patent Application Laid-open No. 48633/1992). By this method, however, the deposited polymer on the recent superfine semiconductor circuits cannot completely be removed in many cases.

Therefore, there has been desired a method for forming a superfine circuit pattern by a detergent for a semiconductor device which can avoid the after-corrosion and can completely remove the deposited polymer and which does not corrode various kinds of metallic materials forming wires.

As described above, there has now been desired a semiconductor circuit detergent which can easily remove the deposited polymer formed on the sidewalls of a metallic material layer and a photo-resist formed on an inorganic substrate and can inhibit the generation of the after-corrosion in a manufacturing process of semiconductor circuits and which does not corrode various kinds of metallic materials forming a fine pattern during the process.

### SUMMARY OF THE INVENTION

An object of the present invention is to provide a detergent for a semiconductor circuit which can solve the various problems of the above-mentioned conventional techniques and which can completely remove a deposited polymer formed during dry etching to avoid the generation of after-corrosion and which does not at all corrode various kinds of metallic materials forming a fine circuit pattern.

Another object of the present invention is to provide a method for manufacturing a semiconductor circuit having a superfine circuit pattern by the use of the above-mentioned detergent.

The present inventors have intensively investigated with the intention of solving the various problems of the conventional techniques, and as a result, it has been found that the employment of a detergent comprising a specific quaternary ammonium hydroxide, a water-soluble organic solvent, and, if necessary, an aqueous solution containing a sugar (saccharide) and/or an sugar alcohol (alditol) can achieve the above-mentioned object. The present invention has been completed on the basis of this finding.

That is to say, the first aspect of the present invention is directed to a detergent for a semiconductor circuit which comprises (A) 0.01 to 15% by weight of a quaternary ammonium hydroxide represented by the general formula (1) 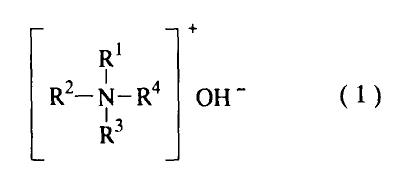 (wherein R¹ to R⁴ are each independently an alkyl group having 1 to 4 carbon atoms, a hydroxy-substituted alkyl group having 1 to 4 carbon atoms, an aryl group having 6 to 8 carbon atoms, or an arylalkyl group having 7 to 9 carbon atoms), (B) 20 to 95% by weight of a water-soluble organic solvent, and (C) the balance of water.

The second aspect of the present invention is directed to a detergent for a semiconductor circuit which comprises the above-mentioned (A), (B), (C) and (D) 0.1 to 20% by weight of a sugar and/or an sugar alcohol.

### BRIEF DESCRIPTION OF THE DRAWINGS

Fig. 1 is a cross-sectional view of a semiconductor circuit obtained by performing dry etching through a resist film as a mask, and then forming aluminum wires.

Fig. 2 is a cross-sectional view of a semiconductor circuit obtained by performing dry etching through a resist film as a mask, and then forming a through-hole.

Fig. 3 is a cross-sectional view of a semiconductor circuit obtained by performing dry etching through a resist film as a mask, removing the resist by an oxygen plasma ashing treatment, and then forming aluminum wires.

Fig. 4 is a cross-sectional view of a semiconductor circuit obtained by performing dry etching through a resist film as a mask, removing the resist by an oxygen plasma ashing treatment, and then forming a through-hole.
1: Semiconductor circuit substrate
2: Oxide film (SiO₂)
3: Ti layer
4: TiN layer
5: Al-Cu layer
6: Resist residue (deposited polymer)
7: Resist layer
8: Oxide film (SiO₂)
   8-1: First TEOS (oxide film formed by the use of tetraethyl orthosilicate) layer
   8-2: SOG layer (spin-on-glass)
   8-3: Second TEOS layer
9: TiN layer
10: Al-Cu layer
11: Deposited polymer
12: Resist layer

### DESCRIPTION OF PREFERRED EMBODIMENTS OF THE INVENTION

In the present invention, as a quaternary ammonium hydroxide (A) represented by the above-mentioned general formula (1), various kinds of compounds can be used. In the general formula (1), R¹ to R⁴ are each independently an alkyl group having 1 to 4 carbon atoms, a hydroxy-substituted alkyl group having 1 to 4 carbon atoms, an aryl group having 6 to 8 carbon atoms, or an arylalkyl group having 7 to 9 carbon atoms. Examples of the alkyl group having 1 to 4 carbon atoms include a methyl group, an ethyl group, a propyl group and a butyl group, and examples of the hydroxy-substituted alkyl group having 1 to 4 carbon atoms include a hydroxymethyl group, a hydroxyethyl group, a hydroxypropyl group and a hydroxybutyl group. Examples of the aryl group having 6 to 8 carbon atoms include a phenyl group, a tolyl group and a xylyl group, and examples of the arylalkyl group having 7 to 9 carbon atoms include a benzyl group and a phenetyl group. Typical examples thereof include tetramethylammonium hydroxide, tetraethylammonium hydroxide, tetrapropylammonium hydroxide, trimethylethylammonium hydroxide, benzyltrimethylammonium hydroxide, trimethyl(2-hydroxyethyl)ammonium hydroxide, triethyl(2-hydroxyethyl)ammonium hydroxide, tripropyl(2-hydroxyethyl)-ammonium hydroxide and trimethyl(1-hydroxypropyl)ammonium hydroxide.

Above all, tetramethylammonium hydroxide (hereinafter referred to as "TMAH") and trimethyl(2-hydroxyethyl)-ammonium hydroxide (hereinafter referred to as "choline") are particularly preferable.

The concentration of the quaternary ammonium hydroxide to be used is in the range of 0.01 to 15% by weight, preferably 0.1 to 10% by weight based on the total weight of a detergent. If the concentration of this quaternary ammonium hydroxide is less than the above-mentioned range, a deposited polymer cannot completely be removed, and on the other hand, if it is more than this range, the corrosion of metallic materials cannot be inhibited.

In this specification, the deposited polymer means a reaction product of a photo-resist and a dry etching gas, or a reaction product of the photo-resist, the dry etching gas and the metallic material of a metallic layer to be worked, but as the case may be, it means a modified photo-resist.

Examples of a water-soluble organic solvent (B) which can be used in the present invention include alcohols such as methanol, ethanol, isopropanol, ethylene glycol and glycerin, ketones such as acetone, methyl ethyl ketone and methyl isopropyl ketone, lactones such as γ-butyrolactone, esters such as methyl lactate and ethyl lactate, nitriles such as acetonitrile, ethers such as alkylene glycol derivatives represented by the general formula R⁵O(CₘH₂ₘO)ₙR⁶ (wherein R⁵ and R⁶ are each independently hydrogen or an alkyl group having 1 to 4 carbon atoms; m is an integer of 2 to 4; and n is an integer of 1 to 4), particularly ethers such as ethylene glycol monomethyl ether, ethylene glycol monoethyl ether, diethylene glycol, diethylene glycol monomethyl ether, diethylene glycol monoethyl ether, triethylene glycol monomethyl ether, diethylene glycol dimethyl ether and dipropylene glycol dimethyl ether; sulfones such as sulfolane, and sulfoxides such as dimethyl sulfoxide. Above all, ethers such as diethylene glycol monomethyl ether, diethylene glycol monoethyl ether, dipropylene glycol monomethyl ether are particularly preferable. These water-soluble organic solvents can be used singly or in the state of a mixture of two or more thereof. The amount of the water-soluble organic solvent to be used is in the concentration range of 20 to 95% by weight, preferably 30 to 80% by weight, more preferably 50 to 80% by weight. If the concentration of the water-soluble organic solvent is outside the above-mentioned range, a washing effect is low, so that the removal of the deposited polymer is incomplete.

Furthermore, in the detergent of the present invention, for the purpose of lowering a corrosion rate of the metallic materials, a sugar and/or an sugar alcohol (D) can be added, as desired. Typical examples of this sugar include glyceraldehydes having 3 to 6 carbon atoms, threose, erythrose, arabinose, xylose, ribose, ribulose, xylulose, glucose, mannose, galactose, tagatose, allose, altrose, gulose, idose, talose, sorbose, psicose and fruit sugar.

Moreover, examples of the sugar alcohol include threitol, erythritol, adonitol, arabitol, xylitol, talitol, sorbitol, mannitol, iditol and dulcitol.

These sugars and sugar alcohols can be used singly or in the state of a mixture of two or more thereof. The total amount of the sugar and/or the sugar alcohol to be used is in the concentration range of 0.1 to 20% by weight, preferably 0.5 to 15% by weight. If the amount of the sugar and/or the sugar alcohol is less than the above-mentioned range, an improvement effect of the corrosion prevention cannot be observed, and on the other hand, if it is more than the above-mentioned range, a removal rate of the deposited polymer is inconveniently low.

The detergent for a semiconductor circuit of the present invention can be used to remove the remaining resist or deposited polymer on the layer to be worked, after the dry etching of an inorganic substrate or after the dry etching and then an ashing treatment by an oxygen plasma. In removing the deposited polymer by the use of the detergent for the semiconductor circuit of the present invention, ordinary temperature is usually enough, but in the case that the removal of the resist is performed without any ashing treatment or in the case that the removal rate of the deposited polymer is noticeably low, heating, ultrasonic wave or the like may be utilized, if necessary.

As techniques of the washing by the use of the detergent of the present invention, various methods are present, and for example, an immersion method, a spray method or the like can suitably be selected. No particular restriction is put on a washing temperature and a washing time, and they may suitably be selected in consideration of a state of the resist and the deposited polymer to be washed, a kind of used metallic materials, and a kind of dry etching gas. Furthermore, as a rinse which can be used in the present invention, an alcoholic solvent such as isopropanol or another organic solvent can be used without any problem, but it is not particularly necessary to use such an organic solvent. Rinsing can be carried out only with superpure water.

As described above, by the use of the detergent for the semiconductor circuit of the present invention, there can easily be removed the photo-resist and the deposited polymer generated on the sidewalls of the layer to be worked and the photo-resist at a time when a fine circuit pattern is formed by the dry etching after the formation of a mask by the use of a desired photo-resist pattern on the metallic material on the inorganic substrate. Additionally, at this time, any corrosion does not occur by the etching, so that the metallic material is not corroded at all, which permits a superfine work. Moreover, it is not necessary to use an organic solvent such as an alcohol as the rinse, and the rinsing can be performed with water alone, which makes it possible to form the highly precise and fine circuit pattern.

Next, the present invention will be described in more detail in accordance with examples. However, the scope of the present invention should not be limited at all by these examples.

### Examples 1 to 6 and Comparative Examples 1 to 4

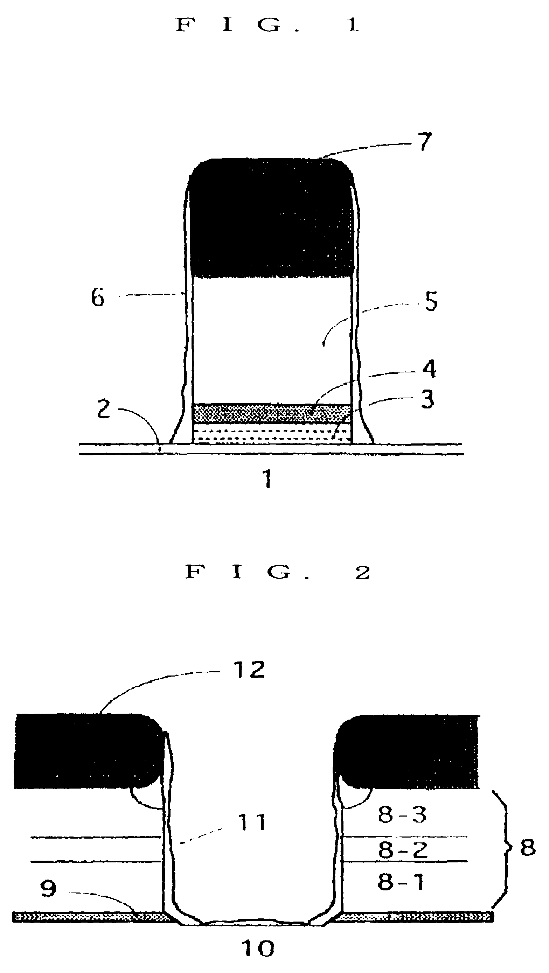

Fig. 1 shows a sectional view of a part of a semiconductor circuit obtained by carrying out dry etching through a resist film as a mask to form aluminum wires. In Fig. 1, a semiconductor circuit substrate 1 is covered with an oxide film 2, and on this oxide film 2, there are formed a Ti layer 3 as a first metallic layer, a TiN layer 4 as a second metallic layer and an Al-Cu layer 5 as a third metallic layer. Furthermore, a resist residue (a deposited polymer) 6 is formed on sidewalls during the dry etching. This deposited polymer 6 covers the sidewalls of the resist layer 7 and the metallic layers 3, 4, 5.

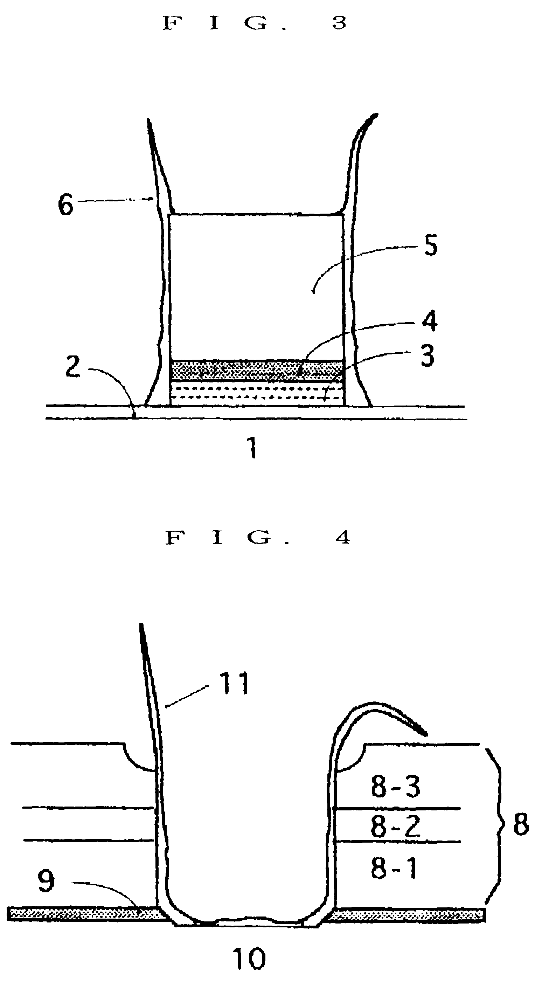

Fig. 2 shows a sectional view of a part of a semiconductor circuit obtained by carrying out the dry etching of an oxide film 8 comprising a first TEOS (an SiO₂ layer formed by the use of tetraethyl orthosilicate) layer 8-1, an SOG (spin-on-glass) layer 8-2 and a second TEOS layer 8-3 through a resist film as a mask, and then forming a through-hole. In Fig. 2, the bottom of the through-hole comprises an Al-Cu layer 10 covered with a TiN layer 9, and during the dry etching, the TiN layer 9 is etched similarly to the oxide film 8, so that the Al-Cu layer 10 is exposed on the surface. The sidewalls of the resist layer 12 and the through-hole are covered with a deposited polymer 11.

After the semiconductor circuit was immersed for a predetermined time in a semiconductor circuit detergent having each of compositions shown in Table 1, it was rinsed with superpure water, dried, and then observed through a scanning type microscope (SEM). For removal properties of the resist layers 7, 12 and the deposited polymers 6, 11 as well as corrosion properties of the wire Al-Cu layer 5 and the through-hole bottom Al-Cu layer 10, evaluation was made by the SEM observation. The results are shown in Table 1.

An evaluation standard in the SEM observation is as follows. Incidentally, on the Ti layer 3, the TiN layers 4, 9, and the oxide layers 2, 8, any corrosion was not observed.

### Removal properties

- ⓞ:: The deposited polymer was completely removed.
- ○:: The deposited polymer was partially observed.
- X:: Most of the deposited polymer was left.

### Corrosion properties

- ⓞ:: The corrosion was not observed at all.
- ○:: The corrosion was partially observed.
- X:: The noticeable corrosion was observed.

### Examples 7 to 12 and Comparative Examples 5 to 8

Fig. 3 shows a sectional view of a part of a semiconductor circuit obtained by carrying out dry etching through a resist film as a mask to form aluminum wires, and then doing an ashing treatment with oxygen plasma. In Fig. 3, a semiconductor circuit substrate 1 is covered with an oxide film 2, and on this oxide film 2, there are formed a Ti layer 3 as a first metallic layer, a TiN layer 4 as a second metallic layer and an Al-Cu layer 5 as a third metallic layer. Additionally, in Fig. 3, a resist layer is removed, but a deposited polymer 6 is not removed and remains so as to outwardly spread from the upper surface of the wires.

Fig. 4 shows a sectional view of a part of a semiconductor circuit obtained by carrying out the dry etching of an oxide film 8 comprising a first TEOS (an SiO₂ layer formed by the use of tetraethyl orthosilicate) layer 8-1, an SOG (spin-on-glass) layer 8-2 and a second TEOS layer 8-3 through a resist film as a mask, forming a through-hole, and then doing an ashing treatment with oxygen plasma. In Fig. 4, the bottom of the through-hole comprises an Al-Cu layer 10 covered with a TiN layer 9, and during the dry etching, the TiN layer 9 is etched similarly to the oxide film 8, so that the Al-Cu layer 10 is exposed on the surface. A resist layer is removed, but a deposited polymer 11 in the through-hole remains in the state of a crown.

After the semiconductor circuit was immersed for a predetermined time in a semiconductor circuit detergent having each of compositions shown in Table 2, it was rinsed with superpure water, dried, and then observed through a scanning type microscope (SEM). For removal properties of the deposited polymers 7, 11 as well as corrosion properties of the wire Al-Cu layer 5 and the through-hole bottom Al-Cu layer 10, evaluation was made by the SEM observation. The results are shown in Table 2.

An evaluation standard in the SEM observation is as follows. Incidentally, on the Ti layer 3, the TiN layers 4, 9, and the oxide layers 2, 8, any corrosion was not observed.

### Removal properties

- ⓞ:: The deposited polymer was completely removed.
- ○:: The deposited polymer was partially observed.
- X:: Most of the deposited polymer was left.

### Corrosion properties

- ⓞ:: The corrosion was not observed at all.
- ○:: The corrosion was partially observed.
- X:: The noticeable corrosion was observed.

**Table 1 (I)**

| | Detergent Composition | | | |
|---|---|---|---|---|
| | Quaternary Ammonium Hydroxide | wt% | Water-soluble Organic Solvent | wt% |
| Example 1 | Tetramethylammonium hydroxide | 2.0 | Diethylene glycol monoethyl ether | 90.0 |
| Example 2 | Tetramethylammonium hydroxide | 2.5 | Ethylene glycol monoethyl ether | 70.0 |
| Example 3 | Tetramethylammonium hydroxide | 2.5 | Sulfolane | 70.0 |
| Example 4 | Tetramethyl ammonium hydroxide | 2.5 | Diethylene glycol monomethyl ether | 70.0 |
| Example 5 | Tetramethylammonium hydroxide | 0.5 | Dipropylene glycol monomethyl ether | 80.0 |
| Example 6 | Choline | 0.5 | Dipropylene glycol monomethyl ether | 80.0 |
| Comp. Example 1 | Tetramethylammonium hydroxide | 2.0 | | |
| Comp. Example 2 | Tetramethylammonium hydroxide | 2.5 | Diethylene glycol monomethyl ether | 70.0 |
| Comp. Example 3 | Tetramethylammonium hydroxide | 2.5 | | |
| Comp. Example 4 | | | Diethylene glycol monomethyl ether | 90.0 |

**Table 1 (II)**

| | Detergent Composition | | | Treatment Conditions | |
|---|---|---|---|---|---|
| | Sugar/Sugar Alcohol | wt% | Water (wt%) | Temp. (°C) | Time (min) |
| Example 1 | | | 8.0 | 50 | 10 |
| Example 2 | Glucose | 5.0 | 22.5 | 50 | 10 |
| Example 3 | Glucose | 7.0 | 22.5 | 50 | 10 |
| Example 4 | Sorbitol | 7.0 | 22.5 | 50 | 10 |
| Example 5 | Sorbitol | 0.5 | 19.0 | 70 | 10 |
| Example 6 | Sorbitol | 0.5 | 19.0 | 70 | 10 |
| Comp. Ex. 1 | | | 98.0 | 50 | 10 |
| Comp. Ex. 2 | | | 27.5 | 50 | 10 |
| Comp. Ex. 3 | Glucose | 7.0 | 92.5 | 50 | 10 |
| Comp. Ex. 4 | | | 10.0 | 70 | 10 |

**Table 1 (III)**

| | State of Treated Wires | | | State of Treated Through-Hole | | |
|---|---|---|---|---|---|---|
| | Removal State of Deposited Polymer 6 | Removal State of Resist 7 | Corrosion State of Al Alloy 5 | Removal State of Deposited Polymer 11 | Removal State of Resist 12 | Corrosion State of Al Alloy 10 |
| Example 1 | ⓞ | ⓞ | ⓞ | ⓞ | ⓞ | ⓞ |
| Example 2 | ⓞ | ⓞ | ⓞ | ⓞ | ⓞ | ⓞ |
| Example 3 | ⓞ | ⓞ | ⓞ | ⓞ | ⓞ | ⓞ |
| Example 4 | ⓞ | ⓞ | ⓞ | ⓞ | ⓞ | ⓞ |
| Example 5 | ⓞ | ⓞ | ⓞ | ⓞ | ⓞ | ⓞ |
| Example 6 | ⓞ | ⓞ | ⓞ | ⓞ | ⓞ | ⓞ |
| Comp. Ex. 1 | ○ | X | X | ○ | X | X |
| Comp. Ex. 2 | ⓞ | ⓞ | ○ | ⓞ | ⓞ | ○ |
| Comp. Ex. 3 | ○ | X | X | ○ | X | X |
| Comp. Ex. 4 | X | ○ | ⓞ | X | X | ⓞ |

**Table 2 (I)**

| | Detergent Composition | | | |
|---|---|---|---|---|
| | Quaternary Ammonium Hydroxide | wt% | Hydrophilic Organic Solvent | wt% |
| Example 7 | Tetramethylammonium hydroxide | 0.5 | Diethylene glycol monoethyl ether | 90.0 |
| Example 8 | Tetramethylammonium hydroxide | 0.5 | Ethylene glycol monoethyl ether | 60.0 |
| Example 9 | Tetramethylammonium hydroxide | 0.5 | Sulfolane | 60.0 |
| Example 10 | Tetramethyl ammonium hydroxide | 0.5 | Diethylene glycol monomethyl ether | 60.0 |
| Example 11 | Tetramethylammonium hydroxide | 0.5 | Dipropylene glycol monomethyl ether | 40.0 |
| Example 12 | Choline | 0.5 | Dipropylene glycol monomethyl ether | 60.0 |
| Comp. Example 5 | Tetramethylammonium hydroxide | 0.5 | | |
| Comp. Example 6 | Tetramethylammonium hydroxide | 0.5 | Diethylene glycol monomethyl ether | 60.0 |
| Comp. Example 7 | Tetramethylammonium hydroxide | 0.5 | | |
| Comp. Example 8 | | | Diethylene glycol monomethyl ether | 90.0 |

**Table 2 (II)**

| | Detergent Composition | | | Treatment Conditions | |
|---|---|---|---|---|---|
| | Sugar/Sugar Alcohol | wt% | Water (wt%) | Temp. (°C) | Time (min) |
| Example 7 | | | 9.5 | 23 | 5 |
| Example 8 | Glucose | 0.5 | 39.0 | 30 | 5 |
| Example 9 | Glucose | 0.5 | 39.0 | 23 | 5 |
| Example 10 | Sorbitol | 0.5 | 39.0 | 23 | 5 |
| Example 11 | Sorbitol | 1.0 | 58.5 | 23 | 5 |
| Example 12 | Sorbitol | 0.5 | 39.0 | 23 | 5 |
| Comp. Ex. 5 | | | 99.5 | 23 | 5 |
| Comp. Ex. 6 | | | 39.5 | 23 | 5 |
| Comp. Ex. 7 | Glucose | 7.0 | 92.5 | 23 | 5 |
| Comp. Ex. 8 | | | 10.0 | 70 | 10 |

**Table 2 (III)**

| | State of Treated Wires | | State of Treated Through-Hole | |
|---|---|---|---|---|
| | Removal State of Deposited Polymer 6 | Corrosion State of Al Alloy 5 | Removal State of Deposited Polymer 11 | Corrosion State of Al Alloy 10 |
| Example 7 | ⓞ | ⓞ | ⓞ | ⓞ |
| Example 8 | ⓞ | ⓞ | ⓞ | ⓞ |
| Example 9 | ⓞ | ⓞ | ⓞ | ⓞ |
| Example 10 | ⓞ | ⓞ | ⓞ | ⓞ |
| Example 11 | ⓞ | ⓞ | ⓞ | ⓞ |
| Example 12 | ⓞ | ⓞ | ⓞ | ⓞ |
| Comp. Ex. 5 | ○ | X | ○ | X |
| Comp. Ex. 6 | ⓞ | ○ | ⓞ | ○ |
| Comp. Ex. 7 | ○ | ⓞ | ○ | ⓞ |
| Comp. Ex. 8 | X | ⓞ | X | ⓞ |

## Claims

1. A detergent for a semiconductor circuit which comprises (A) 0.01 to 15% by weight of a quaternary ammonium hydroxide represented by the general formula (1) 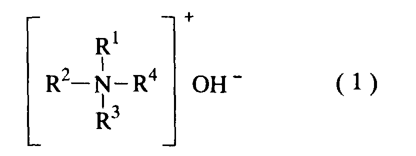 (wherein R¹ to R⁴ are each independently an alkyl group having 1 to 4 carbon atoms, a hydroxy-substituted alkyl group having 1 to 4 carbon atoms, an aryl group having 6 to 8 carbon atoms, or an arylalkyl group having 7 to 9 carbon atoms), (B) 20 to 95% by weight of a water-soluble organic solvent, and (C) the balance of water.

2. A detergent for a semiconductor circuit which comprises (A) 0.01 to 15% by weight of a quaternary ammonium hydroxide represented by the above-mentioned general formula (1), (B) 20 to 95% by weight of a water-soluble organic solvent, (D) 0.1 to 20% by weight of at least one selected from a sugar and an sugar alcohol, and (C) the balance of water.

3. The detergent for a semiconductor circuit according to Claim 1 or 2 wherein the water-soluble organic solvent is an ether.

4. The detergent for a semiconductor circuit according to Claim 3 wherein the ether is an alkylene glycol derivative represented by the general formula R⁵O(CₘH₂ₘO)ₙR⁶ (wherein R⁵ and R⁶ are each independently hydrogen or an alkyl group having 1 to 4 carbon atoms; m is an integer of 2 to 4; and n is an integer of 1 to 4).

5. A method for manufacturing a semiconductor circuit which comprises the steps of forming a mask on a metallic material layer on an inorganic substrate by the use of a photo-resist film, dry-etching a non-masked region of the metallic material, and removing the remaining photo-resist layer of the formed mask and a deposited polymer with a detergent for a semiconductor circuit described in Claim 1 or 2.

6. A method for manufacturing a semiconductor circuit which comprises the steps of forming a mask on a metallic material layer on an inorganic substrate by the use of a photo-resist film, dry-etching a non-masked region of the metallic material, subjecting the photo-resist layer of the formed mask to an ashing treatment, and then removing a remaining deposited polymer with a detergent for a semiconductor circuit described in Claim 1 or 2.
